(19) Europäisches Patentamt / European Patent Office / Office européen des brevets

(11) **EP 3 503 047 B1**

(12) **EUROPÄISCHE PATENTSCHRIFT**

(45) Veröffentlichungstag und Bekanntmachung des Hinweises auf die Patenterteilung:
**27.01.2021   Patentblatt 2021/04**

(51) Int Cl.:
***G07D 7/04*** *(2016.01)*

(21) Anmeldenummer: **17210229.5**

(22) Anmeldetag: **22.12.2017**

(54) **VORRICHTUNG ZUM NACHWEIS EINES MAGNETISCHEN SICHERHEITSMERKMALS EINES WERTDOKUMENTS UND VERFAHREN ZUR MESSWERTKOMPENSATION FÜR DEN NACHWEIS EINES MAGNETISCHEN SICHERHEITSMERKMALS EINES WERTDOKUMENTS**

APPARATUS FOR THE DETECTION OF A MAGNETIC SECURITY FEATURE OF A VALUE DOCUMENT AND METHOD FOR VALUE COMPENSATION FOR THE DETECTION OF A MAGNETIC SECURITY FEATURE OF A VALUABLE DOCUMENT

DISPOSITIF DE DÉTECTION D'UNE CARACTÉRISTIQUE DE SÉCURITÉ MAGNÉTIQUE D'UN DOCUMENT DE VALEUR ET PROCÉDÉ DE COMPENSATION DE LA VALEUR DE MESURE POUR LA DÉTECTION D'UNE CARACTÉRISTIQUE DE SÉCURITÉ MAGNÉTIQUE D'UN DOCUMENT DE VALEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.06.2019   Patentblatt 2019/26**

(73) Patentinhaber: **CI Tech Sensors AG**
**3400 Burgdorf (CH)**

(72) Erfinder:
  • **SCHLETTI, Reto**
    **3400 Burgdorf (CH)**
  • **PAUL, Elisabeth**
    **3400 Burgdorf (CH)**

(74) Vertreter: **Viering, Jentschura & Partner mbB**
**Patent- und Rechtsanwälte**
**Am Brauhaus 8**
**01099 Dresden (DE)**

(56) Entgegenhaltungen:
**US-A1- 2017 352 222**

**Beschreibung**

Die vorliegende Erfindung betrifft eine Vorrichtung zum Nachweis eines magnetischen Sicherheitsmerkmals eines Wertdokuments und ein Verfahren zur Messwertkompensation für den Nachweis eines magnetischen Sicherheitsmerkmals eines Wertdokuments.

Wertdokumente wie Wertscheine oder beispielsweise Banknoten, Schecks, Aktien, Papiere mit Sicherheitsaufdruck, Urkunden, Ausweise, Reisepässe, Eintrittskarten, Fahrkarten, Gutscheine, Identifikations- oder Zugangskarten oder Ähnliches können auf deren Frontseite, deren Rückseite und/oder im Material eingebettet mit Sicherheitsmerkmalen versehen sein, um eine Fälschung davon zu erschweren oder zu verhindern sowie deren Echtheit überprüfen zu können. Im beispielhaften Fall einer Banknote können einige dieser Sicherheitsmerkmale, z.B. ein mit magnetischer Tinte bedruckter Bereich der Banknote, maschinenprüfbar sein.

Banknoten werden mittels Bankautomaten an Kunden ausgegeben, z.B. im Rahmen einer Auszahlung von einem Bankkonto, und/oder können von Kunden Banknoten entgegennehmen, z.B. bei einer Einzahlung auf ein Bankkonto. Wenn eine Banknote durch einen Bankautomaten gehandhabt wird, erfolgt eine Echtheitsprüfung der Banknote anhand der Sicherheitsmerkmale durch eine Handhabungsvorrichtung des Bankautomaten, um die Banknote im Fall einer Fälschung einzuziehen. Die Überprüfung von dem z.B. magnetischen Sicherheitsmerkmal in der Handhabungsvorrichtung erfolgt z.B. durch magnetoresistive Sensoren, welche jedoch auch andere Magnetfelder erfassen als die des magnetischen Sicherheitsmerkmals, beispielsweise von Antriebsmotoren, Ventilatoren, etc. des Bankautomaten.

Aufgrund der im Vergleich zu den anderen Magnetfeldern geringen Größe des durch das magnetische Sicherheitsmerkmal erzeugten Magnetfeldes erschweren andere Magnetfelder die sichere Erfassung des magnetischen Sicherheitsmerkmals - und somit die Echtheitsprüfung der Banknote.

Beispielsweise sind aus der US 2017/0352222 A1 eine Sensoranordnung und ein Verfahren zum Erfassen von Fälschungsinformationen einer Banknote bekannt.

In Antwort hierauf werden eine Vorrichtung und ein Verfahren zur Messwertkompensation bei der Erfassung von magnetischen Sicherheitsmerkmalen in einer Handhabungsvorrichtung bereitgestellt, welche ein sicheres automatisches Erfassen von magnetischen Sicherheitsmerkmalen in einer Handhabungsvorrichtung ermöglichen.

Die vorliegende Erfindung stellt eine Vorrichtung zum Nachweis eines magnetischen Sicherheitsmerkmals eines Wertdokuments gemäß Anspruch 1 und ein Verfahren zur Messwertkompensation gemäß Anspruch 8 bereit. Weitere Ausführungsformen der Vorrichtung bzw. des Verfahrens sind in den jeweiligen abhängigen Ansprüchen beschrieben.

Eine Vorrichtung zum Nachweis eines magnetischen Sicherheitsmerkmals eines Wertdokuments gemäß einer beispielhaften Ausführungsform kann eine Transportvorrichtung, Sensoren und eine Auswertungseinheit aufweisen. Die Vorrichtung kann eingerichtet sein, das Wertdokument, entgegenzunehmen, zu überprüfen und wieder auszugeben (Handhabung des Wertdokuments). Zudem kann die Vorrichtung eingerichtet sein, zusätzlich zu einem magnetischen Sicherheitsmerkmal andere Arten von Sicherheitsmerkmalen zu erfassen.

Ein Wertdokument (z.B. eine Banknote) kann ein flacher, beispielsweise rechteckiger, Gegenstand sein und kann eine erste Flachseite sowie eine dieser ersten Flachseite gegenüberliegende zweite Flachseite aufweisen. Im Fall eines rechteckigen Wertdokuments kann dieses einen langen und einen im Verhältnis dazu kurzen Rand aufweisen. Auf einer der Flachseiten und/oder im Material des Wertdokuments selbst kann zumindest ein maschinenlesbares magnetisches Sicherheitsmerkmal bereitgestellt sein. Die Vorrichtung kann beispielsweise in einem Bankautomaten bereitgestellt sein. Zudem kann die Vorrichtung ebenfalls in zahlreichen Arten von Automaten bereitgestellt sein, welche Wertdokumente handhaben, z.B. in Einzahlungs-, Fahrkarten-, Lebensmittel- und Getränkeautomaten.

Die Transportvorrichtung kann beispielsweise eingerichtet sein, das Wertdokument auf einer (z.B. ebenen oder gekrümmten) Transportebene in einer Transportrichtung durch die Vorrichtung hindurch zu transportieren (z.B. mittels Rollen- und/oder Bandfördermittel). Die Transportebene kann (z.B. zumindest im Wesentlichen) senkrecht zu einer Schwerkraftrichtung oder (z.B. zumindest im Wesentlichen) parallel zur Schwerkraftrichtung ausgerichtet sein. Während des Transports des Wertdokuments durch die Transportvorrichtung können sich die Flachseiten des Wertdokuments (z.B. zumindest im Wesentlichen) parallel zur Transportebene erstrecken. Das Wertdokument kann beispielsweise mit einem langen oder kurzen Rand voran durch die Transportvorrichtung transportierbar sein, mit einer beliebigen der Flachseiten nach oben weisen und ist nicht auf eine Art von Wertdokumenten festgelegt.

Die Sensoren können beispielsweise als magnetfeldsensitive Sensoren ("Magnetsensoren") eingerichtet sein, z.B. als magnetoresistive Sensoren. Beispielsweise kann bei den Sensoren durch Anlegen eines äußeren Magnetfeldes der elektrische Widerstand der Sensoren geändert werden und so berührungslos ein magnetischen Sicherheitsmerkmal beim Transport des Wertdokuments an den Sensoren vorbei erfassbar sein. Beispielsweise können die Sensoren als Hall-Sensoren ausgeführt sein, welche berührungslos ein Magnetfeld erfassen und ein korrespondierendes Spannungssignal ausgeben. Jedoch sind auch andere Arten von Sensoren möglich, beispielsweise optische, taktile und/oder kapazitive Sensoren. Als die Sensoren sind zumindest zwei (beispielsweise drei, vier, fünf, sechs, sieben, acht, neun, zehn, elf, zwölf oder mehr) Sicherheitsmerkmalsensoren und zumindest ein (z.B. zwei, drei oder mehr) Kompensationssensor(en) bereitgestellt. Die Anzahl der Sensoren richtet sich nach dem handzuhabenden Wertdokument. Die Sicherheitsmerkmalsensoren können eingerichtet sein, ein Magnetfeld innerhalb der Transportebene zu erfassen, welches z.B. durch ein Sicherheitsmerkmal oder durch eine Störung durch eine andere Komponente (z.B. einen elektrischen Antriebsmotor der Transportvorrichtung) erzeugt wird, und der Kompensationssensor kann eingerichtet sein, ein Magnetfeld außerhalb (z.B. oberhalb) der Transportebene zu erfassen, welches z.B. durch die Störung erzeugt wird. Die Sensoren können in einer (z.B. geraden oder gekrümmten) Linie (z.B. zumindest im Wesentlichen) parallel zur Transportebene und (z.B. zumindest im Wesentlichen) quer zur Transportrichtung angeordnet sein. Beispielsweise kann sich die Linie der Sensoren (z.B. zumindest im Wesentlichen) entlang der gesamten Länge des langen Rands des Wertdokuments erstrecken, d.h., die Sensoren können über die gesamte Länge des langen Rands des Wertdokuments verteilt sein. Alternativ kann die Linie der Sensoren zur Transportrichtung einen Winkel aufweisen und alternativ kann die Linie der Sensoren nur einer Teillänge des langen Rands des Wertdokuments entsprechen. Die Sensoren können z.B. weiter eingerichtet sein, dass beim Transport des Wertdokuments vorbei an der Linie der Sensoren die Sicherheitsmerkmalsensoren jeweils einen einzelnen Streifen des Wertdokuments in der Transportrichtung erfassen. Beispielsweise verlaufen die Streifen (z.B. zumindest im Wesentlichen) parallel zum kurzen Rand des Wertdokuments. Auf diese Art ist beispielsweise das gesamte Wertdokument beim Transport durch die Vorrichtung hindurch erfassbar. Weiter können die Sensoren mit einem Abstand zur Transportebene angeordnet sein. Der Abstand eines der Sicherheitsmerkmalsensoren kann z.B. derart eingerichtet sein, dass ein Sicherheitsmerkmal durch den Sicherheitsmerkmalsensor erfassbar ist, und der Abstand des Kompensationssensors kann derart eingerichtet sein, dass ein Sicherheitsmerkmal durch den Kompensationssensor nicht erfassbar ist. Beispielsweise können einer der Sicherheitsmerkmalsensoren und der Kompensationssensor bezüglich der Transportebene übereinander (z.B. teilweise oder vollständig überlappend) angeordnet sein, beispielsweise um entlang der Linie der Sensoren Platz zu sparen.

Die Auswertungseinheit kann z.B. eingerichtet sein, die von den Sensoren ausgegebenen Signale zu empfangen. Hierzu kann die Auswertungseinheit beispielsweise mittels elektrischer und/oder optischer Leitungen mit den Sensoren verbunden sein. Weiter kann die Auswertungseinheit beispielsweise eingerichtet sein, anhand der empfangenen Signale zu ermitteln, ob von einem Sicherheitsmerkmalsensor ein Sicherheitsmerkmal erfasst wird.

Die Vorrichtung kann beispielsweise weiter eingerichtet sein, sodass der oder die Kompensationssensoren symmetrisch zu einer Mitte der Linie angeordnet ist oder sind. Die Mitte der Linie kann (z.B. zumindest im Wesentlichen) zu einer Mitte des voran transportierten Rands des Wertdokuments oder einer maximalen Transportbreite korrespondieren, innerhalb welcher ein Wertdokument durch die Vorrichtung hindurch transportierbar ist. Wenn zum Beispiel ein einzelner Kompensationssensor verwendet wird, kann dieser auf der Mittellinie angeordnet sein. Wenn z.B. zwei Kompensationssensoren verwendet werden, können diese am Anfang und am Ende der Linie angeordnet sein. Wenn z.B. drei Kompensationssensoren verwendet werden, können diese am Anfang, in der Mitte und am Ende der Linie angeordnet sein. Beispielsweise können die Kompensationssensoren gleichmäßig entlang der Linie der Sensoren verteilt sein, um entlang dieser gleichmäßig Magnetfelder zu erfassen. Zudem können die Kompensationssensoren in einem Bereich der Linie der Sensoren angeordnet sein, in welchem ein starkes störendes Magnetfeld zu erwarten ist.

Der Abstand der Sicherheitsmerkmalsensoren zur Transportebene (bspw. zum in der Transportebene transportierten Wertdokument) kann beispielsweise in etwa 1,8 mm, bevorzugt in etwa 1,3 mm und weiter bevorzugt in etwa 0,5 mm betragen, und der Abstand des oder der Kompensationssensoren zur Transportebene kann in etwa 5 mm bis 10 mm und bevorzugt in etwa 8 mm betragen. Somit wird ein Erfassen eines Sicherheitsmerkmals durch den Sicherheitsmerkmalsensor sichergestellt und ein Erfassen durch den Kompensationssensor vermieden.

Die Sensoren können weiter z.B. als Magnetsensoren vom gleichen Typ eingerichtet sein.

Das Wertdokument kann z.B. eines der folgenden sein: eine Banknote, ein Scheck, ein Identitätsnachweis, ein Reisepass, ein Fahrschein und ein Aktiendokument.

Beim Verfahren zum Nachweis eines magnetischen Sicherheitsmerkmals eines Wertdokuments gemäß einer beispielhaften Ausführungsform kann ein Wertdokument durch eine Vorrichtung mit zumindest zwei Sicherheitsmerkmalsensoren und zumindest einem Kompensationssensor transportiert werden (z.B. durch eine Transportvorrichtung der Vorrichtung), wobei die Sensoren als Magnetsensoren (z.B. magnetoresistive Sensoren oder Hall-Sensoren) eingerichtet sind. Wenn kein Wertdokument an den Sensoren vorbei transportiert wird, können die folgenden Schritte ausgeführt werden: Erfassen, durch die Sicherheitsmerkmalsensoren und den Kompensationssensor, eines jeweiligen Messwerts (z.B. eines störenden Magnetfelds, wobei der Messwert z.B. als analoges Spannungssignal ausgebbar ist), Ermitteln (z.B. durch eine Auswertungseinheit) einer Störgröße des jeweiligen Sicherheitsmerkmal- und Kompensationssensors basierend auf seinem Messwert, Ermitteln (z.B. durch die Auswertungseinheit) eines Gewichtungsfaktors für den jeweiligen Sicherheitsmerkmalsensor abhängig von einem Abstand (z.B. entlang der Linie der Sensoren) des Sicherheitsmerkmalsensors vom Kompensationssensor, Berechnen (z.B. durch die Auswertungseinheit) eines Kompensationsfaktors für den jeweiligen Sicherheitsmerkmalsensor (z.B. dessen Signal) basierend auf dem Verhältnis der erfassten Störgrößen des Sicherheitsmerkmalsensors und des Kompensationssensors sowie dem Gewichtungsfaktor (beispielsweise wird der Kompensationsfaktor umso weniger vom Gewichtungsfaktor beeinflusst, je weiter der entsprechende Sicherheitsmerkmalsensor vom Kompensationssensor entfernt ist), Berechnen (z.B. durch die Auswertungseinheit) eines Kompensationswerts für den jeweiligen Sicherheitsmerkmalsensor basierend auf dem Kompensationsfaktor und dem Messwert und Berechnen (z.B. durch die Auswertungseinheit) eines kompensierten Messwerts des jeweiligen Sicherheitsmerkmalsensors. Ein derart kompensierter Sicherheitsmerkmalsensor kann ohne zusätzliche Maßnahmen (z.B. eine magnetische Abschirmung gegenüber magnetischen Störfeldern) ein magnetisches Sicherheitsmerkmal eines Wertdokuments sicher erfassen.

Das Verfahren kann beispielsweise ferner ein Sicherheitsmerkmal unter Verwendung des kompensierten Messwerts nachweisen, wenn ein Wertdokument an den Sensoren vorbei transportiert wird.

Das Ermitteln der Störgröße kann z.B. unter Verwendung einer Standardabweichung oder eines quadratischen Mittels mehrerer Messwerte erfolgen.

Bei dem Verfahren kann beispielsweise in einem Fall, in welchem ein einzelner Kompensationssensor verwendet wird, beim Ermitteln des Gewichtungsfaktors ein für alle Sicherheitsmerkmalsensoren gleicher Gewichtungsfaktor ermittelt werden. Weiter kann z.B. in einem Fall, in welchem mehrere Kompensationssensoren verwendet werden, beim Ermitteln des Gewichtungsfaktors ein Gewichtungsfaktor pro Kompensationssensor für einen jeweiligen Sicherheitsmerkmalsensor ermittelt werden, der mit zunehmendem Abstand des Sicherheitsmerkmalsensors vom zugehörigen Kompensationssensor abnimmt. Beispielsweise in dem Fall von zwei Kompensationssensoren jeweils am Ende der Linie der Sensoren wird ein großer Gewichtungsfaktor für den einen Sicherheitsmerkmalsensor ermittelt, welcher sich nahe an dem einen Kompensationssensor befindet, und wird ein kleiner Gewichtungsfaktor für den anderen Sicherheitsmerkmalsensor ermittelt, der sich weiter entfernt von dem einen Kompensationssensor befindet. Analog wird dies für den anderen Kompensationssensor ausgeführt, sodass in diesem Fall jeder Sicherheitsmerkmalsensor zwei Gewichtungsfaktoren bereitgestellt bekommt, um dadurch Ungenauigkeiten des entfernteren der Kompensationssensoren in der Gewichtung zu reduzieren, da die vom Kompensationssensor erfasste Störung am weit entfernten Sicherheitsmerkmalsensor eine andere (unbekannte) Stärke haben kann.

Weiter kann beim Verfahren beispielsweise in dem Fall des einzelnen Kompensationssensors beim Berechnen des Kompensationsfaktors für den Sicherheitsmerkmalsensor eine Extrapolation des Störgrößenverhältnisses ausgehend vom Kompensationssensor basierend auf dem Gewichtungsfaktor erfolgen. Beispielsweise wird für alle Sicherheitsmerkmalsensoren der gleiche Gewichtungsfaktor verwendet oder wird ausgehend vom Kompensationssensor mit zunehmendem Abstand davon ein z.B. linear abfallender Gewichtungsfaktor für die Sicherheitssensoren verwendet. Weiter kann beispielsweise in dem Fall mehrerer Kompensationssensoren eine stückweise lineare Interpolation des Störgrößenverhältnisses zwischen den Kompensationssensoren basierend auf den Gewichtungsfaktoren erfolgen. Es kann z.B. jeweils von Kompensationssensor zu Kompensationssensor interpoliert werden. Beispielsweise kann in dem Fall, wenn die Kompensationssensoren nicht am Anfang oder Ende der Linie der Sensoren angeordnet sind, d.h., wenn weitere Sicherheitsmerkmalsensoren außerhalb der Kompensationssensoren angeordnet sind, anhand der Interpolation zwischen den Kompensationssensoren das Störgrößenverhältnis für die folgenden Sicherheitsmerkmalsensoren extrapoliert werden. Somit ist der Kompensationsfaktor für verschiedene Sensoranordnungen berechenbar.

Weiter kann beim Verfahren z.B. das Ermitteln des Gewichtungsfaktors erfolgen, indem dem Gewichtungsfaktor (z.B. zusätzlich) ein Wert in der Größenordnung des Signalrauschens der Sensoren hinzuaddiert wird.

Ausführungsbeispiele der Vorrichtung sowie des Verfahrens sind in den Figuren dargestellt bzw. werden im Folgenden näher erläutert.

Es zeigen:

Figuren 1A und 1B     eine schematische Anordnung von Sicherheitsmerkmal- und Kompensationssensoren in einer Vorrichtung zur Handhabung von Banknoten, wobei Figur 1A eine Draufsicht und Figur 1B eine Vorderansicht der Vorrichtung zeigt,

Figur 2     eine schematische Darstellung von Störungen und deren Einfluss auf die Messwerte bei einer Anordnung von Sensoren gemäß den Figuren 1A und 1B,

Figur 3     eine schematische Darstellung von Kompensationswerten bei einer Anordnung von Sensoren gemäß den Figuren 1A und 1B,

Figur 4     eine schematische Darstellung von kompensierten Messwerten bei einer Anordnung von Sensoren gemäß den Figuren 1A und 1B, und

Figur 5     ein Flussdiagramm eines Verfahrens zur Messwertkompensation für das Erfassen von Banknoten-Sicherheitsmerkmalen in einer Vorrichtung zur Handhabung von Banknoten.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeführt werden kann. In dieser Hinsicht wird Richtungsterminologie wie etwa "oben", "unten", "links", "rechts" usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Weiter versteht sich, dass auch die Indizierung von Merkmalen mit z.B. "erste(s/r)", "zweite(s/r)", usw. nur der Veranschaulichung dient und auf keinerlei Weise einschränkend ist. Es versteht sich ebenfalls, dass die Merkmale der hierin beschriebenen verschiedenen beispielhaften Ausführungsformen miteinander kombiniert werden können, sofern nicht spezifisch anders angegeben. Weiter können Verfahrensschritte in einer anderen als der beschriebenen Reihenfolge ausgeführt werden; beispielsweise kann das unten beschriebene Ermitteln der Gewichtungsfaktoren unabhängig von anderen Verfahrensschritten erfolgen und/oder kann z.B. die Entscheidung, ob eine Banknote an den Sensoren vorliegt, an irgendeiner Stelle im Verfahren nach dem unten beschrieben Erfassen der Messwerte ohne Banknote erfolgen. Die folgende ausführliche Beschreibung ist deshalb nicht in einschränkendem Sinne aufzufassen, und der Schutzumfang der vorliegenden Erfindung wird durch die angefügten Ansprüche definiert.

In den Figuren werden identische oder ähnliche Elemente mit identischen Bezugszeichen versehen, soweit dies zweckmäßig ist. Weiter können in den Figuren Dicken von Linien zur besseren Darstellbarkeit übertrieben gezeichnet sein; beispielsweise kann die Dicke einer Banknote bzw. des Sicherheitsmerkmals in den Figuren übertrieben dargestellt sein, jedoch im Verhältnis zu anderen Abmessungen tatsächlich klein sein.

Dies trifft auch auf die wie hierin verwendete "Transportebene" zu, welche z.B. eine Mittenebene eines Transportspalts sein kann, innerhalb welchem die Banknoten transportiert werden. Ein derartiger Transportspalt kann eine Dicke von z.B. in etwa 0,1 mm bis 2 mm haben. Das heißt, die Banknoten können innerhalb des Transportspalts z.B. auch ober- oder unterhalb der Transportebene transportiert werden. Zum Zweck der verbesserten Darstellbarkeit werden im Folgenden die Banknoten in der Transportebene gezeigt.

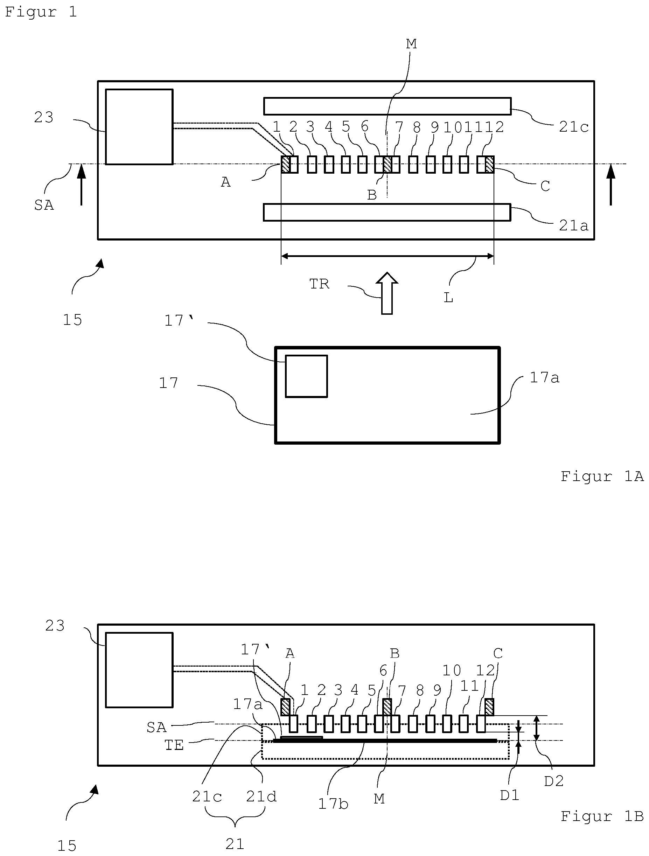

**Fig.1A** und **Fig.1B** zeigen eine Anordnung eines ersten bis zwölften Sicherheitsmerkmalsensors 1-12 und eines ersten bis dritten Kompensationssensors A, B, C in einer Vorrichtung 15 zur Handhabung von Wertdokumenten 17, wobei Fig.1A eine Draufsicht und Fig.1B eine Vorderansicht der Handhabungsvorrichtung 15 ist. Die Vorrichtung kann beispielsweise in einem nicht gezeigten Bankautomaten installiert sein und kann weiter eingerichtet sein, andere als ein magnetisches Sicherheitsmerkmal zu erfassen. Hierzu kann die Vorrichtung 15 weitere Sensoren aufweisen. Weiter trifft die folgende Beschreibung auch analog auf andere Anordnungen von Sicherheitsmerkmal- und Kompensationssensoren mit beispielsweise zwei, drei, vier, fünf, usw. Sicherheitsmerkmalsensoren und mit einem, zwei, drei, vier usw. Kompensationssensoren zu.

Wie in Fig.1A gezeigt ist als Wertdokument eine Banknote 17 von unten in die Handhabungsvorrichtung 15 einführbar, wobei die Banknote 17 ein rechteckiger, flacher Gegenstand aus z.B. Papier mit einer ersten Flachseite 17a und einer der ersten Flachseite 3a gegenüberliegenden zweiten Flachseite 17b ist. Ein Bereich der ersten Flachseite 17a ist mit magnetischer Tinte bedruckt und stellt ein magnetisches Sicherheitsmerkmal 17' dar, welches durch die Sicherheitsmerkmalsensoren 1-12 erfassbar ist. Alternativ oder zusätzlich kann auch die zweite Flachseite 17b ein magnetisches Sicherheitsmerkmal aufweisen. Zudem ist es auch möglich, dass das magnetische Sicherheitsmerkmal in der Banknote eingebettet ist, bspw. in der Art eines Sicherheitsfadens.

Weiter ist die Banknote 17 nicht auf eine Art von Banknote festgelegt, sondern steht stellvertretend für eine Vielzahl von verschiedenen Banknoten, z.B. unterschiedlicher Stückelung (physische Größe der Banknote) einer oder verschiedener Währungen. In der weiteren Beschreibung ist zur einfacheren Darstellung ein Fall beschrieben, in welchem die Banknote 17 mit ihrer ersten Flachseite 17a und dem Sicherheitsmerkmal 17' nach oben weist und mit einem ihrer langen Ränder voran durch die Vorrichtung 15 transportiert wird; jedoch ist es ebenfalls möglich, dass die zweite Flachseite 17b nach oben weist, die Banknote 17 mit einem ihrer kurzen Ränder voran durch die Vorrichtung 15 transportiert wird und/oder das Sicherheitsmerkmal 17' im Material der Banknote 17 angeordnet ist.

Die Banknote 17 ist von z.B. einem (nicht dargestellten) Banknoteneinzug in die Vorrichtung 15 einführbar und durch eine Transportvorrichtung 21 auf einer Transportebene TE (Zeichnungsebene) in einer Transportrichtung TR durch die Vorrichtung 15 hindurch zur oberen Seite transportierbar. Die erste und die zweite Flachseite 17a, 17b sind hierbei in der Transportebene TE angeordnet. Beispielsweise weist die Transportvorrichtung 21 zumindest ein Paar Rollen 21a, 21b auf, welche achsparallel quer zur Transportrichtung TR oberhalb und unterhalb der Transportebene TE angeordnet sind und einen Spalt bilden, in welchem die Banknote 17 durch die Rollen 21a, 21b hindurch transportierbar ist (Fig.1A und Fig.1B zeigen beispielhaft zwei Rollenpaare, wobei die Rollen 21a, 21c und 21d sichtbar sind). Zum Transport kontaktieren die Rollen 21a, 21b und 21c, 21d jeweils eine der Flachseiten 17a, 17b der Banknote 17 und ist zumindest eine der Rollen 21a, 21b, 21c, 21d angetrieben, z.B. durch einen (nicht gezeigten) Elektromotor. Weiter kann die Transportvorrichtung 21 eine Banknotenführung (nicht gezeigt) aufweisen, welche verhindert, dass die Banknote die Transportebene TE verlässt; dies kann z.B. eine Führungsplatte sein, an welcher die Banknote beim Transport anliegt (z.B. entlanggleitet). Die Transportgeschwindigkeit ist durch eine Auswertungseinheit 23 steuerbar, welche hierzu mit der Transportvorrichtung 21 verbunden ist (nicht gezeigt). Nach dem Durchlaufen der Vorrichtung 15 ist die Banknote 17 an der oberen Seite der Vorrichtung 15 ausgebbar, z.B. in ein Lagerfach (nicht gezeigt).

Die Sicherheitsmerkmal- und Kompensationssensoren 1-12, A-C sind auf einer Achse SA angeordnet, welche quer zur Transportrichtung TR und parallel zur sowie oberhalb der Transportebene TE verläuft. Die Sensoren sind, in der Fig.1A von links nach rechts betrachtet und mit dem ersten Kompensationssensor A beginnend, in der Reihenfolge erster Kompensationssensor A, erster bis sechster Sicherheitsmerkmalsensor 1-6, zweiter Kompensationssensor B, siebter bis zwölfter Sicherheitsmerkmalsensor 7-12 und dritter Kompensationssensor C angeordnet, wobei eine Länge L der Linie der Sensoren vom ersten bis zum dritten Kompensationssensor A, C reicht. Die Länge L kann sich beispielsweise zumindest im Wesentlichen über die Länge des Rands der Banknote 17 erstrecken, mit welchem diese voran transportiert wird. Die Linie L kann zwischen ihren Enden eine Mitte M haben, an welcher der zweite Kompensationssensor B angeordnet ist. Die Sicherheitsmerkmalsensoren 1-12 sind hier symmetrisch zur Mitte M mit gleichen Abständen entlang der Linie L angeordnet, wobei die Kompensationssensoren A-C direkt neben dem ersten, zwischen dem sechsten und dem siebten und neben dem zwölften Sicherheitssensor 1, 6, 7, 12 angeordnet sind. Anstatt der versetzten Anordnung der Sensoren können die Kompensationssensoren A-C überlappend mit den Sicherheitsmerkmalsensoren 1-12 angeordnet sein; beispielsweise kann der erste Kompensationssensor A oberhalb des ersten Sicherheitsmerkmalsensors 1 und der dritte Kompensationssensor C oberhalb des zwölften Sicherheitsmerkmalsensors 12 angeordnet sein, um die Länge L kurz zu halten. Die Sicherheitsmerkmal- und Kompensationssensoren 1-12, A-C können auf unterschiedlichen Seiten der Transportebene TE angeordnet sein. Die Auswertungseinheit 23 ist mittels Leitungen (beispielhaft sind zwei strichlierte Leitungen in Fig.1A und Fig.1B gezeigt) mit den Sensoren verbunden, um deren Signale zu empfangen und diese mit Energie zu versorgen. Beispielsweise geben die Sensoren ein analoges Spannungssignal in Abhängigkeit eines gemessenen Magnetfelds aus (Messwert). Weiter kann die Auswertungseinheit 23 mit einem Kommunikationssystem des Bankautomaten verbunden sein, um von diesem Befehle zu empfangen und Informationen zu übertragen.

Fig.1B ist eine Ansicht auf die Achse SA in der Fig.1A und stellt schematisch eine Vorderansicht der Vorrichtung 15 da, wobei sich die Transportrichtung TR in die Zeichnungsebene hinein erstreckt. Im Hintergrund sind in der Vorrichtung 15 gepunktet die Rollen 21c, 21d der Transportvorrichtung 21 gezeigt. Die Sicherheitsmerkmalsensoren 1-12 sind mit einem ersten Abstand D1 senkrecht zur Transportebene TE angeordnet (oberhalb), und die Kompensationssensoren A-C sind mit einem zweiten Abstand D2 senkrecht zur Transportebene TE angeordnet. Der zweite Abstand D2 ist größer als der erste Abstand D1, sodass die Kompensationssensoren A-C das Sicherheitsmerkmal 17' nicht erfassen können, wohingegen die Sicherheitsmerkmalsensoren 1-12 das Sicherheitsmerkmal 17' erfassen können, wenn dieses unter den entsprechenden Sensoren hindurch transportiert wird. Da etwaige störende Magnetfelder sowohl von den Kompensations- wie auch den Sicherheitsmerkmalsensoren A-C, 1-12 erfassbar sind, die Sicherheitsmerkmale 17' der Banknoten 17 jedoch nur von den Sicherheitsmerkmalsensoren 1-12 erfassbar sind, können die Kompensationssensoren A-C verwendet werden, um aufgrund ihrer Messwerte den Einfluss der störenden Magnetfelder auf die Sicherheitsmerkmalsensoren 1-12 zu kompensieren. Mit der oben beschriebenen Anordnung bzw. dem nachfolgend beschriebenen Verfahren ist es mit einer geringen Anzahl an Kompensationssensoren möglich, eine im Verhältnis dazu große Anzahl an Sicherheitsmerkmalsensoren zu kompensieren.

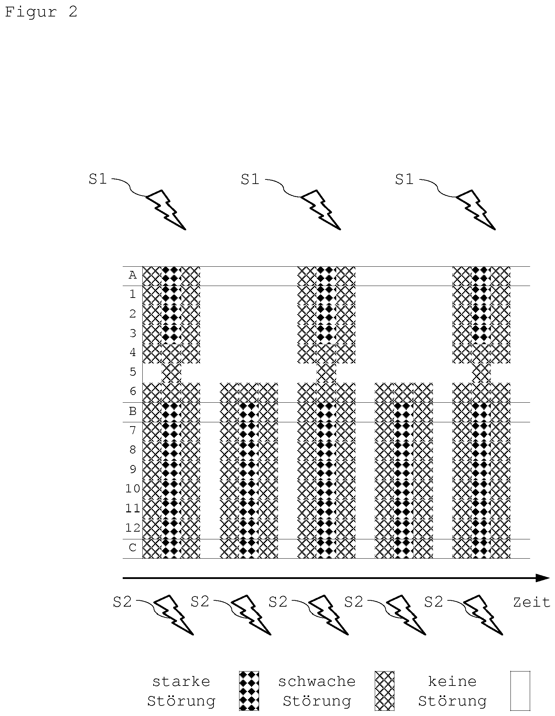

Fig.2 zeigt eine schematische Darstellung von Störungen und deren Einfluss auf die Messwerte bei einer Anordnung von Sensoren gemäß Fig.1A und Fig.1B.

In Fig.2 ist schematisch eine Draufsicht auf die Transportebene TE der Vorrichtung 15 gezeigt, wobei in der Transportebene TE Störungen durch andere Magnetfelder auftreten. In der Darstellung sind die von den Kompensations- und Sicherheitsmerkmalsensoren 1-12, A-C (Ordinate) ausgegebenen Messwerte über die Zeit (Abszisse) aufgetragen, d.h., ein zeitlicher Signalverlauf der Sensoren 1-12, A-C ist dargestellt. Die Messwerte der Sensoren 1-12, A-C repräsentieren einen Zustand ohne erfasstes Sicherheitsmerkmal 17', jedoch mit erfassten störenden Magnetfeldern. Am oberen und am unteren Rand der Darstellung treten zyklisch ein erstes bzw. ein zweites störendes Magnetfeld auf, beispielsweise am oberen Rand durch einen Elektromotor und am unteren Rand durch einen Ventilator des Bankautomaten. Die hervorgerufenen Störungen S1 (oben) und S2 (unten) sind beispielhaft und können mit anderer Stärke, Frequenz, zusammen mit weiteren Störungen, etc. auftreten. Die Messwerte der Sensoren 1-12, A-C unter Einfluss der Störungen S1, S2 sind hier beispielhaft in die Kategorien "starke Störung", "schwache Störung" und "keine Störung" eingeteilt, wobei zahlreiche (nicht gezeigte) Zwischenstufen vorliegen, da es sich bei den Messwerten beispielsweise um analoge Spannungssignale handelt. Eine starke Störung bewirkt einen großen Messwert, eine schwache Störung einen kleinen Messwert und keine Störung hat z.B. das übliche Rauschen des Sensors 1-12, A-C als Ausgabe (Messwert) zur Folge.

Es ist ersichtlich, dass die Störung S1 synchron mit halber Frequenz zur Störung S2 auftritt. Es ist weiter ersichtlich, das die Störungen S1, S2 abhängig vom zeitlichen Auftreten einen starken bis keinen Einfluss auf die Sensoren haben, d.h., die Störungen S1, S2 sind zeitlich veränderlich. Aufgrund der Störung S1 geben der erste Kompensationssensor A und der erste Sicherheitsmerkmalsensor bis fünfte Sicherheitsmerkmalsensor 1-5 einen großen, einen kleinen bzw. keinen Messwert (z.B. vernachlässigbares Rauschen) aus, d.h., sind von der Störung S1 stark bis nicht beeinflusst. Aufgrund der Störung S2 geben der zweite und der dritte Kompensationssensor B, C und der sechste Sicherheitsmerkmalsensor bis zwölfte Sicherheitsmerkmalsensor 6-12 einen großen, einen kleinen bzw. keinen Messwert (z.B. vernachlässigbares Rauschen) aus, d.h., sind von der Störung S2 stark bis nicht beeinflusst. Für den Fall, dass ein Sicherheitsmerkmal 17' einer Banknote 17 erfasst werden soll, wenn z.B. gleichzeitig die Störung S2 erfasst wird, können z.B. zumindest der siebte bis zwölfte Sicherheitsmerkmalsensor 7-12 das Sicherheitsmerkmal 17' nicht von der Störung S2 unterscheiden, sodass das Sicherheitsmerkmal 17' nicht oder fehlerhaft erfassbar ist.

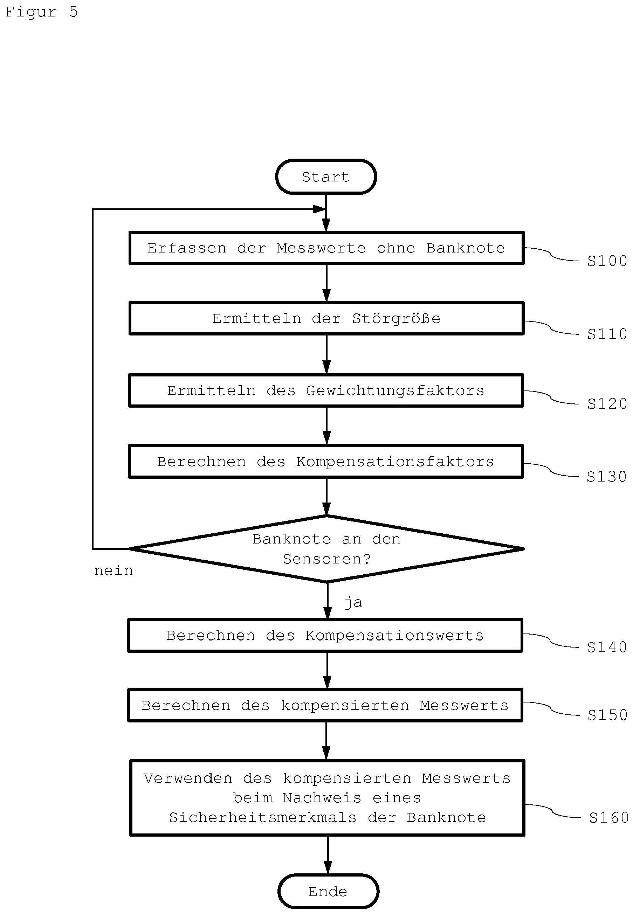

Unter Bezugnahme auf die Fig.2 bis Fig.5 ist weiter ein Verfahren zur Messwertkompensation und zur Verwendung eines kompensierten Messwerts beim Nachweis eines magnetischen Sicherheitsmerkmals 17' einer Banknote 17 beschrieben, wobei in der Fig.5 die einzelnen Verfahrensschritte dargestellt sind. Das Verfahren kann z.B. durch die Auswertungseinrichtung 23 gesteuert gestartet werden, z.B., wenn eine Anforderung durch den Bankautomaten erfolgt. Gemäß dem folgenden Verfahren ist es möglich, den Einfluss der Störungen S1, S2 auf die Sicherheitsmerkmalsensoren 1-12 zu berücksichtigen, um ein sicheres Erfassen eines Sicherheitsmerkmals 17' einer Banknote 17 ohne aufwendiges magnetisches Abschirmen der Vorrichtung 15 zu gewährleisten. Im Weiteren werden zur einfacheren Darstellung für Werte/Größen, welche die Sicherheitsmerkmalsensoren 1-12 betreffen, auch der Index i (i = erster Sicherheitsmerkmalsensor bis zwölfter Sicherheitsmerkmalsensor 1 bis 12) und für Werte/Größen, welche die Kompensationssensoren A-C betreffen, auch der Index j (j = erster Kompensationssensor bis dritter Kompensationssensor A bis C) verwendet.

Wenn keine Banknote an den Sensoren vorbeitransportiert wird, z.B. in einem Zeitraum zwischen zwei aufeinander folgenden Banknoten, wird für jeden Kompensations- und Sicherheitsmerkmalsensor A-C, 1-12 ein zugehöriger Messwert $M_j$, $M_i$ erfasst (S100), beispielsweise in der Art eines analogen Spannungssignals (Rohsignals). Das Erfassen der Messwerte $M_j$, $M_i$ erfolgt durch die Auswertungseinrichtung 23, welche die Spannungssignale von jedem der Sensoren A-C, 1-12 empfängt. In der Fig.2 sind die Messwerte $M_j$, $M_i$, welche aufgrund der Störungen S1, S2 von den Kompensations- und Sicherheitsmerkmalsensoren A-C, 1-12 ausgegeben werden, im zeitlichen Verlauf dargestellt.

Nach dem Erfassen wird eine jeweilige Störgröße $S_j$, $S_i$ der Kompensations- und Sicherheitsmerkmalsensoren A-C, 1-12 durch die Auswertungseinrichtung 23 aus den Messwerte $M_j$, $M_i$ ermittelt (S110). Das Ermitteln der Störgröße $S_j$, $S_i$ kann beispielsweise unter Verwendung der Standardabweichung oder des quadratischen Mittels mehrerer aufeinanderfolgender Messwerte $M_j$, $M_i$ der Kompensations- und Sicherheitsmerkmalsensoren A-C, 1-12 erfolgen. Die Messwerte $M_j$, $M_i$ werden über eine vorbestimmte Zeit erfasst, ohne dass eine Banknote in dieser Zeit erfasst wird, d.h., es werden die Störgrößen $S_j$, $S_i$ nur aus den Messwerten $M_j$, $M_i$ der Störungen S1, S2 ermittelt. Beispielsweise können die Störgrößen $S_j$, $S_i$ als Störamplitude bzgl. eines ungestörten Ausgabesignals der Sensoren ermittelt werden.

Im Anschluss an das Ermitteln wird ein Gewichtungsfaktor $G_{ji}$ für den jeweiligen Sicherheitsmerkmalsensor 1-12 abhängig von einem Abstand des Sicherheitsmerkmalsensors 1-12 vom Kompensationssensor A-C entlang der Linie L ermittelt (S120). Aufgrund der symmetrischen Anordnung der Kompensationssensoren A-C, d.h. am Anfang, in der Mitte M und am Ende der Linie L, liegen an drei Stellen der Linie L genaue Störgrößen $S_j$, $S_i$ durch die Kompensationssensoren A-C vor, welche jedoch mit zunehmenden Abstand von den Kompensationssensoren A-C ungenauer werden können. Das heißt, eine Störgröße $S_B$ kann z.B. für den Fall der Störung S2 (starke Störung) zur Störung des siebten und des achten Sicherheitsmerkmalsensor 7, 8 (starke Störung) korrespondieren, wohingegen die Störgröße $S_B$ die Störung S2 des vierten und des fünften Sicherheitsmerkmalsensors 4, 5 (keine Störung) falsch abbildet. Folglich ist eine Gewichtung der Störgrößen $S_j$, $S_i$ der Kompensationssensoren A-C mit zunehmendem Abstand davon erforderlich, welche hier in der Art einer Interpolation erfolgt. Hierfür werden für die Sicherheitsmerkmalsensoren 1-12 die Gewichtungsfaktoren $G_{ji}$ bestimmt, mittels welchen der Einfluss der Kompensationssensoren A-C berücksichtigt wird. Je weiter ein Kompensationssensor A-C von einem Sicherheitsmerkmalsensor 1-12 entfernt ist, umso geringer ist der entsprechende Gewichtungsfaktor $G_{ji}$. Die jeweiligen Gewichtungsfaktoren $G_{ji}$ ergeben sich ausgehend von den Kompensationssensoren A-C für die Sicherheitsmerkmalsensoren 1-12 wie folgt:

| Kompensationssensor | | Sicherheitsmerkmalsensor | | | | | | | | | | | |
|---|---|---|---|---|---|---|---|---|---|---|---|---|
| | | 1 | 2 | 3 | 4 | 5 | 6 | 7 | 8 | 9 | 10 | 11 | 12 |
| | A | $G_{A1}$ $11/11$ | $G_{A2}$ $9/11$ | $G_{A3}$ $7/11$ | $G_{A4}$ $5/11$ | $G_{A5}$ $3/11$ | $G_{A6}$ $1/11$ | $G_{A7}$ $0$ | $G_{A8}$ $0$ | $G_{A9}$ $0$ | $G_{A10}$ $0$ | $G_{A11}$ $0$ | $G_{A12}$ $0$ |
| | B | $G_{B1}$ $0$ | $G_{B2}$ $2/11$ | $G_{B3}$ $4/11$ | $G_{B4}$ $6/11$ | $G_{B5}$ $8/11$ | $G_{B6}$ $10/11$ | $G_{B7}$ $10/11$ | $G_{B8}$ $8/11$ | $G_{B9}$ $6/11$ | $G_{B10}$ $4/11$ | $G_{B11}$ $2/11$ | $G_{B12}$ $0$ |
| | C | $G_{C1}$ $0$ | $G_{C2}$ $0$ | $G_{C3}$ $0$ | $G_{C4}$ $0$ | $G_{C5}$ $0$ | $G_{C6}$ $0$ | $G_{C7}$ $1/11$ | $G_{C8}$ $3/11$ | $G_{C9}$ $5/11$ | $G_{C10}$ $7/11$ | $G_{C11}$ $9/11$ | $G_{C12}$ $11/11$ |

Tabelle 1

Aus der Tabelle 1 geht hervor, dass beispielsweise der Messwert $M_5$ des Sicherheitsmerkmalsensors 5 bzgl. des Kompensationssensors A mit 3/11 und bzgl. des Kompensationssensors B mit 8/11 gewichtet wird und der Messwert des Kompensationssensors C nicht berücksichtigt wird. Es geht weiter aus der Tabelle 1 hervor, dass sich die Gewichtungsfaktoren $G_{ji}$ für einen jeweiligen Sicherheitsmerkmalsensor 1-12 zu 11/11, d.h., zu 1, ergänzen. Somit sind die Sicherheitsmerkmalsensoren 1-12 absolut betrachtet alle gleich gewichtet, jeweils mit unterschiedlichen Anteilen bestimmt durch die Gewichtungsfaktoren $G_{ji}$.

Für die beispielhaften Fälle eines einzelnen Kompensationssensors B in der Mitte M der Linie L oder von zwei Kompensationssensoren A, C am Anfang und am Ende der Linie L ergeben sich als Extrapolation bzw. Interpolation die folgenden Gewichtungsfaktoren $G_{ji}$ gemäß Tabelle 2 (einzelner Kompensationssensor B) und Tabelle 3 (zwei Kompensationssensoren A, C):

| Kompensations-sensor | | Sicherheitsmerkmalsensor | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| | B | $G_{B1}$ $11/11$ | $G_{B2}$ $11/11$ | $G_{B3}$ $11/11$ | $G_{B4}$ $11/11$ | $G_{B5}$ $11/11$ | $G_{B6}$ $11/11$ | $G_{B7}$ $11/11$ | $G_{B8}$ $11/11$ | $G_{B9}$ $11/11$ | $G_{B10}$ $11/11$ | $G_{B11}$ $11/11$ | $G_{B12}$ $11/11$ |

Tabelle 2

| | | Sicherheitsmerkmalsensor | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Kompensations-sensor | A | $G_{A1}$ $^{11}/_{11}$ | $G_{A2}$ $^{10}/_{11}$ | $G_{A3}$ $^{9}/_{11}$ | $G_{A4}$ $^{8}/_{11}$ | $G_{A5}$ $^{7}/_{11}$ | $G_{A6}$ $^{6}/_{11}$ | $G_{A7}$ $^{5}/_{11}$ | $G_{A8}$ $^{4}/_{11}$ | $G_{A9}$ $^{3}/_{11}$ | $G_{A10}$ $^{2}/_{11}$ | $G_{A11}$ $^{1}/_{11}$ | $G_{A12}$ 0 |
| | C | $G_{C1}$ 0 | $G_{C2}$ $^{1}/_{11}$ | $G_{C3}$ $^{2}/_{11}$ | $G_{C4}$ $^{3}/_{11}$ | $G_{C5}$ $^{4}/_{11}$ | $G_{C6}$ $^{5}/_{11}$ | $G_{C7}$ $^{6}/_{11}$ | $G_{C8}$ $^{7}/_{11}$ | $G_{C9}$ $^{8}/_{11}$ | $G_{C10}$ $^{9}/_{11}$ | $G_{C11}$ $^{10}/_{11}$ | $G_{C12}$ $^{11}/_{11}$ |

Tabelle 3

Alternativ sind für die in den Tabellen 1 bis 3 dargestellten Gewichtungsfaktorenverläufe auch nicht-lineare Verläufe möglich, z.B., parabolisch oder kubisch, wenn dadurch die zu erwartenden Störungen besser gewichtet werden können. Die Gewichtungsfaktoren $G_{ji}$ können z.B. in der Art eines Kennfelds abhängig von der tatsächlichen Sensoranordnung in der Auswertungseinheit 23 gespeichert sein, sodass auch andere als die zu den Tabellen 1 bis 3 korrespondierende Sensoranordnungen möglich sind.

Nach dem Ermitteln der Gewichtungsfaktoren $G_{ji}$ unter Verwendung der Tabelle 1 wird dann durch die Auswertungseinrichtung 23 ein Kompensationsfaktor $K_{ji}$ für den jeweiligen Sicherheitsmerkmalsensor 1-12 basierend auf dem Verhältnis der ermittelten Störgrößen $S_i$, $S_j$ des Sicherheitsmerkmalsensors 1-12 und des Kompensationssensors A-C sowie des Gewichtungsfaktors $G_{ji}$ wie folgt berechnet (S130) :

$$(1) \qquad K_{ji} = \frac{s_i}{s_j} G_{ji}$$

Das heißt, in diesem Fall werden für jeden Sicherheitsmerkmalsensor 1-12 drei Kompensationsfaktoren $K_{Ai}$, $K_{Bi}$ und $K_{Ci}$ berechnet.

Mit dem Vorliegen der Kompensationsfaktoren $K_{ji}$ kann das weitere Verfahren durchgeführt werden, auch wenn eine Banknote unter den Sicherheitsmerkmalsensoren 1-12 und den Kompensationssensoren A-C hindurch transportiert wird und ggf. ein Sicherheitsmerkmal der Banknote durch einen oder mehrere der Sicherheitsmerkmalsensoren 1-12 erfasst wird.

Im Anschluss hieran wird durch die Auswertungseinrichtung 23 dann ein Kompensationswert Wi (Wert zur Abschätzung der Störung am jeweiligen Sicherheitsmerkmalsensor 1-12) für den jeweiligen Sicherheitsmerkmalsensor 1-12 basierend auf den Kompensationsfaktoren $K_{ji}$ und den Messwerten $M_j$ wie folgt berechnet (S140):

$$(2) \qquad W_i = K_{Ai}M_A + K_{Bi}M_B + K_{Ci}M_C$$

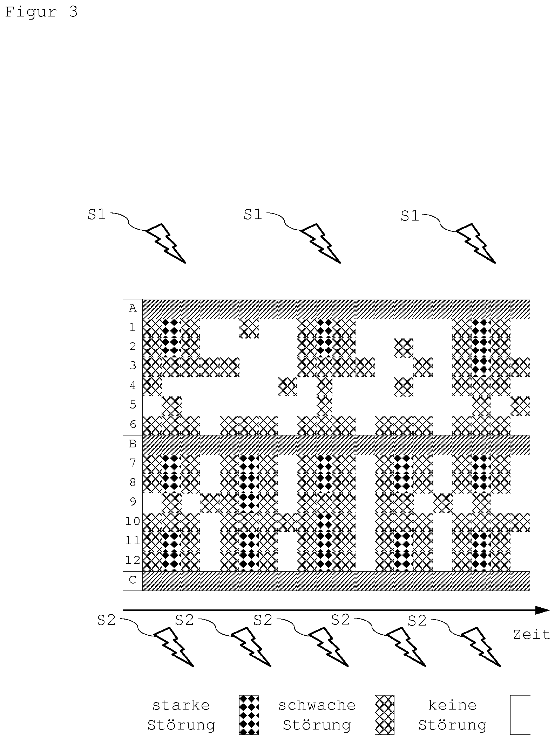

In **Fig.3** sind beispielhaft die Kompensationswerte Wi, aufgrund der Störungen S1, S2 für die Sicherheitsmerkmalsensoren 1-12 im zeitlichen Verlauf dargestellt (Kompensationsbild). Werte der Kompensationssensoren A-C sind nicht dargestellt. Es ist festzustellen, dass die Kompensationswerte Wi umso genauer den Störungen S1, S2 entsprechen, je näher die zugehörigen Sicherheitsmerkmalsensoren 1-12 an den Kompensationssensoren A-C liegen. Durch die Gewichtung wird erreicht, dass beide Störungen S1, S2 auch für die von den Kompensationssensoren A-C weiter entfernten Sicherheitsmerkmalsensoren ausreichend abgebildet werden (vgl. beispielsweise dritter und vierter Sicherheitsmerkmalsensor 3, 4).

Abschließend wird durch die Auswertungseinrichtung 23 ein kompensierter Messwert $kM_i$ des jeweiligen Sicherheitsmerkmalsensors 1-12 wie folgt berechnet (S150):

$$(3) \qquad kM_i = M_i - W_i$$

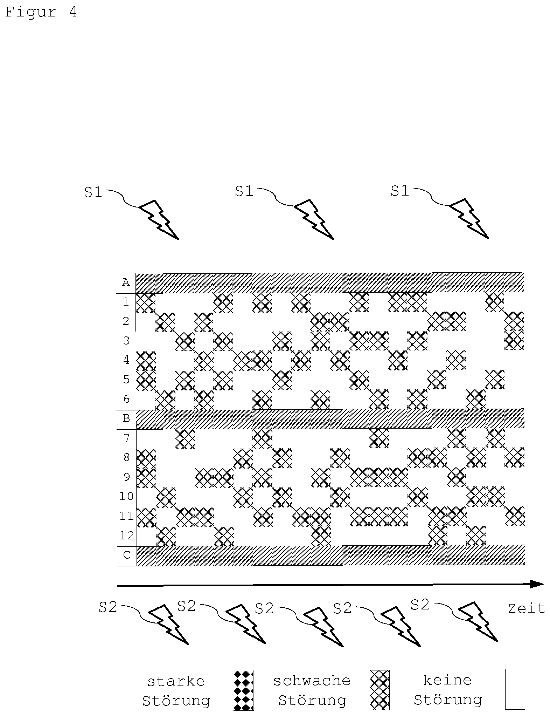

In **Fig.4** sind beispielhaft die kompensierten Messwerte $kM_i$ für die Sicherheitsmerkmalsensoren 1-12 im zeitlichen Verlauf dargestellt (ohne erfasstes Sicherheitsmerkmal der Banknote). Werte der Kompensationssensoren A-C sind nicht dargestellt. Es ist festzustellen, dass die Störungen S1, S2 auf die Sicherheitsmerkmalsensoren 1-12 keinen bis nur einen schwachen Einfluss haben. Die kompensierten Messwerte $kM_i$ werden beim Erfassen eines Sicherheitsmerkmals einer Banknote verwendet (S160). Es ist ersichtlich, dass die kompensierten Messwerte $kM_i$ der Sicherheitsmerkmalsensoren 1-12 lediglich schwache Störungen aufweisen bzw. ungestört sind.

Zudem ist es möglich, dass die Messwerte $M_i$, $M_j$, die Kompensationswerte $W_i$ und/oder die kompensierten Messwert $kM_i$ gefiltert werden, um Störungen der Sicherheitsmerkmalsensoren 1-12 noch weiter zu reduzieren. Dies können beispielsweise Störungen durch Elektroinstallationen (Netzbrummen) oder durch Temperaturänderungen sein.

## Patentansprüche

1. Vorrichtung (15) zum Nachweis eines magnetischen Sicherheitsmerkmals (17') eines Wertdokuments (17), wobei die Vorrichtung (15) aufweist:

   • eine Transportvorrichtung (21), welche eingerichtet ist, das Wertdokument (17) auf einer Transportebene (TE) in einer Transportrichtung (TR) durch die Vorrichtung (15) hindurch zu transportieren,
   • Sensoren (1-12, A-C), welche als Magnetsensoren eingerichtet sind und zumindest zwei Sicherheitsmerkmalsensoren (1-12) und zumindest einen Kompensationssensor (A-C) aufweisen,

   ◦ wobei die Sensoren (1-12, A-C) in einer Linie (L) parallel zur Transportebene (TE) und quer zur Transportrichtung (TR) angeordnet und eingerichtet sind, derart, dass beim Transport des Wertdokuments (1) vorbei an der Linie (L) der Sensoren (1-12, A-C) die Sicherheitsmerkmalsensoren (1-12) jeweils einen einzelnen Streifen des Wertdokuments (1) in der Transportrichtung (TR) erfassen, und
   ◦ wobei die Sensoren (1-12, A-C) mit einem Abstand (D1, D2) senkrecht zur Transportebene (TE) angeordnet sind, derart, dass der Abstand (D1) der Sicherheitsmerkmalsensoren (1-12) senkrecht zur Transportebene (TE) so eingerichtet ist, dass ein Sicherheitsmerkmal (17') durch zumindest einen der Sicherheitsmerkmalsensoren (1-12) erfasst wird, und dass der Abstand (D2) des Kompensationssensors (A-C) senkrecht zur Transportebene (TE) so eingerichtet ist, dass ein Sicherheitsmerkmal (17') durch den Kompensationssensor (A-C) nicht erfasst wird, wobei der Abstand (D2) des Kompensationssensors (A-C) größer ist als der Abstand (D1) der Sicherheitsmerkmalsensoren (1-12), und

   • eine Auswertungseinheit (23), welche eingerichtet ist, die von den Sensoren (1-12, A-C) ausgegebenen Signale zu empfangen.

2. Vorrichtung (15) gemäß Anspruch 1, wobei der oder die Kompensationssensoren (A-C) symmetrisch zu einer Mitte (M) der Linie (L) angeordnet ist oder sind.

3. Vorrichtung (15) gemäß Anspruch 1 oder 2, wobei jeweils ein Kompensationssensor (A-C) am Anfang und am Ende der Linie (L) angeordnet ist.

4. Vorrichtung (15) gemäß einem der vorhergehenden Ansprüche, wobei der Abstand (D1) der Sicherheitsmerkmalsensoren (1-12) zur Transportebene (TE) 1,8 mm, bevorzugt 1,3 mm und weiter bevorzugt 0,5 mm beträgt.

5. Vorrichtung (15) gemäß einem der vorhergehenden Ansprüche, wobei der Abstand (D2) des oder der Kompensationssensoren (A-C) zur Transportebene (TE) 5 mm bis 10 mm und bevorzugt 8 mm beträgt.

6. Vorrichtung (15) gemäß einem der vorhergehenden Ansprüche, wobei die Sensoren (1-12, A-C) als Magnetsensoren vom gleichen Typ eingerichtet sind.

7. Vorrichtung (15) gemäß einem der vorhergehenden Ansprüche, wobei das Wertdokument (17) eines der folgenden ist:

   • eine Banknote;

- ein Scheck;
- ein Identitätsnachweis;
- ein Reisepass;
- ein Fahrschein;
- ein Aktiendokument.

**8.** Verfahren zur Messwertkompensation für den Nachweis eines magnetischen Sicherheitsmerkmals (17') eines Wertdokuments (17), welches durch eine Vorrichtung gemäss Ansprüche 1-7 mit zumindest zwei Sicherheitsmerkmalsensoren (1-12) und zumindest einem Kompensationssensor (A-C) transportiert wird, wobei die Sensoren (1-12, A-C) als Magnetsensoren eingerichtet sind, das Verfahren aufweisend, bevor ein Wertdokument (17) an den Sensoren (1-12, A-C) vorbei transportiert wird:

- Erfassen (S100), durch die Sicherheitsmerkmalsensoren (1-12) und den Kompensationssensor (A-C), eines jeweiligen Messwerts ($M_i$, $M_j$),
- Ermitteln (S110) einer Störgröße ($S_j$, $S_i$) des jeweiligen Sicherheitsmerkmal- und Kompensationssensors (1-12, A-C) basierend auf seinem Messwert ($M_i$, $M_j$),
- Ermitteln (S120) eines Gewichtungsfaktors ($G_{ji}$) für den jeweiligen Sicherheitsmerkmalsensor (1-12) abhängig von einem Abstand des Sicherheitsmerkmalsensors (1-12) vom Kompensationssensor (A-C),
- Berechnen (S130) eines Kompensationsfaktors ($K_{ji}$) für den jeweiligen Sicherheitsmerkmalsensor (1-12) basierend auf dem Verhältnis der erfassten Störgrößen ($S_j$, $S_i$) des Sicherheitsmerkmalsensors (1-12) und des Kompensationssensors (A-C) sowie dem Gewichtungsfaktor ($G_{ji}$),
- Berechnen (S140) eines Kompensationswerts ($W_i$) für den jeweiligen Sicherheitsmerkmalsensor (1-12) basierend auf dem Kompensationsfaktor ($K_{ji}$) und dem Messwert ($M_j$) und
- Berechnen (S150) eines kompensierten Messwerts ($kM_i$) des jeweiligen Sicherheitsmerkmalsensors (1-12).

**9.** Verfahren gemäß Anspruch 8, ferner aufweisend:
Nachweisen (S160) eines Sicherheitsmerkmals (17') unter Verwendung des kompensierten Messwerts ($kM_i$), wenn ein Wertdokument (17) an den Sensoren (1-12, A-C) vorbei transportiert wird.

**10.** Verfahren gemäß Anspruch 8 oder 9,
wobei das Ermitteln (S110) der Störgröße ($S_j$, $S_i$) unter Verwendung einer Standardabweichung oder eines quadratischen Mittels mehrerer Messwerte ($M_i$, $M_j$) erfolgt.

**11.** Verfahren gemäß einem der Ansprüche 8 bis 10,
wobei, wenn ein einzelner Kompensationssensor (A-C) verwendet wird, beim Ermitteln (S120) des Gewichtungsfaktors ($G_{ji}$) ein für alle Sicherheitsmerkmalsensoren (1-12) gleicher Gewichtungsfaktor ($G_{ji}$) ermittelt wird.

**12.** Verfahren gemäß einem der Ansprüche 8 bis 10,
wobei, wenn mehrere Kompensationssensoren (A-C) verwendet werden, beim Ermitteln (S120) des Gewichtungsfaktors ($G_{ji}$) ein Gewichtungsfaktor pro Kompensationssensor (A-C) für einen jeweiligen Sicherheitsmerkmalsensor (1-12) ermittelt wird, welcher mit zunehmendem Abstand des Sicherheitsmerkmalsensors (1-12) vom zugehörigen Kompensationssensor (A-C) abnimmt.

**13.** Verfahren gemäß einem der Ansprüche 8 bis 12,
wobei, wenn ein einzelner Kompensationssensor (A-C) verwendet wird, beim Berechnen des Kompensationsfaktors (S130) für den Sicherheitsmerkmalsensor (1-12) eine Extrapolation des Störgrößenverhältnisses ausgehend vom Kompensationssensor (A-C) basierend auf dem Gewichtungsfaktor ($G_{ji}$) erfolgt, oder, wenn mehrere Kompensationssensoren (A-C) verwendet werden, eine stückweise lineare Interpolation des Störgrößenverhältnisses zwischen den Kompensationssensoren (A-C) basierend auf den Gewichtungsfaktoren ($G_{ji}$) erfolgt.

**14.** Verfahren gemäß einem der Ansprüche 8 bis 13,
wobei beim Ermitteln (S120) des Gewichtungsfaktors ($G_{ji}$) dem Gewichtungsfaktor ein Wert in der Größenordnung des Signalrauschens der Sensoren (1-12) hinzuaddiert wird.

**Claims**

**1.** Apparatus (15) for detecting a magnetic security feature (17') of a valuable document (17), wherein the apparatus (15) has:

• a transport apparatus (21), configured to transport the valuable document (17) through the apparatus (15) on a transport plane (TE) in a direction of transport (TR),
• sensors (1-12, A-C) configured as magnetic sensors and having at least two security feature sensors (1-12) and at least one compensation sensor (A-C),

◦ wherein the sensors (1-12, A-C) are arranged and configured in a line (L) parallel to the transport plane (TE) and transversely with respect to the direction of transport (TR) such that transport of the valuable document (1) past the line (L) of sensors (1-12, A-C) results in the security feature sensors (1-12) each capturing an individual strip of the valuable document (1) in the direction of transport (TR), and
◦ wherein the sensors (1-12, A-C) are arranged at a distance (D1, D2) perpendicularly with respect to the transport plane (TE) such that the distance (D1) of the security feature sensors (1-12) perpendicularly with respect to the transport plane (TE) is configured such that a security feature (17') is captured by at least one of the security feature sensors (1-12), and that the distance (D2) of the compensation sensor (A-C) perpendicularly with respect to the transport plane (TE) is configured such that a security feature (17') is not captured by the compensation sensor (A-C), wherein the distance (D2) of the compensation sensor (A-C) is greater than the distance (D1) of the security feature sensors (1-12), and

• an evaluation unit (23) configured to receive the signals output by the sensors (1-12, A-C).

2. Apparatus (15) according to Claim 1,
   wherein the compensation sensor (s) (A-C) is or are arranged symmetrically in relation to a centre (M) of the line (L).

3. Apparatus (15) according to Claim 1 or 2,
   wherein a respective compensation sensor (A-C) is arranged at the start and at the end of the line (L).

4. Apparatus (15) according to one of the preceding claims,
   wherein the distance (D1) of the security feature sensors (1-12) from the transport plane (TE) is 1.8 mm, preferably 1.3 mm and more preferably 0.5 mm.

5. Apparatus (15) according to one of the preceding claims,
   wherein the distance (D2) of the compensation sensor(s) (A-C) from the transport plane (TE) is 5 mm to 10 mm and preferably 8 mm.

6. Apparatus (15) according to one of the preceding claims,
   wherein the sensors (1-12, A-C) are configured as magnetic sensors of the same type.

7. Apparatus (15) according to one of the preceding claims,
   wherein the valuable document (17) is one of the following:

• a bank note;
• a cheque;
• an identity card;
• a passport;
• a travel ticket;
• a share document.

8. Method for measured value compensation for the detection of a magnetic security feature (17') of a valuable document (17) transported by an apparatus according to Claims 1-7 having at least two security feature sensors (1-12) and at least one compensation sensor (A-C), wherein the sensors (1-12, A-C) are configured as magnetic sensors, the method involving, before a valuable document (17) is transported past the sensors (1-12, A-C):

• capturing (S100), by means of the security feature sensors (1-12) and the compensation sensor (A-C), a respective measured value ($M_i$, $M_j$),
• ascertaining (S110) a disturbance variable ($S_j$, $S_i$) of the respective security feature and compensation sensor (1-12, A-C) based on the measured value ($M_i$, $M_j$) of said sensor,
• ascertaining (S120) a weighting factor ($G_{ji}$) for the respective security feature sensor (1-12) on the basis of a distance of the security feature sensor (1-12) from the compensation sensor (A-C),
• calculating (S130) a compensation factor ($K_{ji}$) for the respective security feature sensor (1-12) based on the ratio of the captured disturbance variables ($S_j$, $S_i$) of the security feature sensor (1-12) and of the compensation sensor (A-C) and on the weighting factor ($G_{ji}$),
• calculating (S140) a compensation value ($W_i$) for the respective security feature sensor (1-12) based on the compensation factor ($K_{ji}$) and the measured value ($M_j$), and
• calculating (S150) a compensated measured value ($kM_i$) of the respective security feature sensor (1-12).

9. Method according to Claim 8, further involving:
detecting (S160) a security feature (17 using the compensated measured value ($kM_i$), when a valuable document (17) is transported past the sensors (1-12, A-C).

10. Method according to Claim 8 or 9,
wherein the disturbance variable ($S_j$, $S_i$) is ascertained (S110) using a standard deviation or a root mean square of multiple measured values ($M_i$, $M_j$).

11. Method according to one of Claims 8 to 10,
wherein if a single compensation sensor (A-C) is used then the ascertaining (S120) of the weighting factor ($G_{ji}$) results in a weighting factor ($G_{ji}$) that is the same for all the security feature sensors (1-12) being ascertained.

12. Method according to one of Claims 8 to 10,
wherein if multiple compensation sensors (A-C) are used then the ascertaining (S120) of the weighting factor ($G_{ji}$) results in one weighting factor per compensation sensor (A-C) being ascertained for a respective security feature sensor (1-12) that decreases as the distance of the security feature sensor (1-12) from the associated compensation sensor (A-C) increases.

13. Method according to one of Claims 8 to 12,
wherein if a single compensation sensor (A-C) is used then the calculating of the compensation factor (S130) for the security feature sensor (1-12) results in an extrapolation of the disturbance variable ratio from the compensation sensor (A-C) being effected based on the weighting factor ($G_{ji}$), or if multiple compensation sensors (A-C) are used then a piecewise linear interpolation of the disturbance variable ratio between the compensation sensors (A-C) is effected based on the weighting factors ($G_{ji}$).

14. Method according to one of Claims 8 to 13,
wherein the ascertaining (S120) of the weighting factor ($G_{ji}$) results in a value in the order of magnitude of the signal noise of the sensors (1-12) being added to the weighting factor.

**Revendications**

1. Dispositif (15) de détection d'une caractéristique de sécurité magnétique (17') d'un document de valeur (17), dans lequel le dispositif (15) comporte :

   • un dispositif de transport (21) qui est conçu pour transporter le document de valeur (17) sur un plan de transport (TE) dans une direction de transport (TR) à travers le dispositif (15),
   • des capteurs (1-12, A-C) qui sont conçus sous la forme de capteurs magnétiques et qui comportent au moins deux capteurs de caractéristique de sécurité (1-12) et au moins un capteur de compensation (A-C),

      o dans lequel les capteurs (1-12, A-C) sont agencés sur une ligne (L) parallèlement au plan de transport (TE) et transversalement à la direction de transport (TR) et sont conçus de telle manière que, lorsque le document de valeur (1) est transporté en passant sur la ligne (L) des capteurs (1-12, A-C), les capteurs de caractéristique de sécurité (1-12) détectent respectivement une bande unique du document de valeur (1) dans la direction de transport (TR), et
      ◦ dans lequel les capteurs (1-12, A-C) sont agencés à une distance (D1, D2) perpendiculairement au plan de transport (TE) de manière à ce que la distance (D1) des capteurs de caractéristique de sécurité (1-12) perpendiculairement au plan de transport (TE) soit établie de telle sorte qu'une caractéristique de sécurité (17') soit détectée par au moins l'un des capteurs de caractéristique de sécurité (1-12), et à ce que la distance (D2) du capteur de compensation (A-C) perpendiculairement au plan de transport (TE) soit établie de telle sorte qu'une caractéristique de sécurité (17') ne soit pas détectée par le capteur de compensation (A-C), dans lequel la distance (D2) du capteur de compensation (A-C) est supérieure à la distance (D1) des capteurs de caractéristique de sécurité (1-12), et

• une unité d'évaluation (23) qui est conçue pour recevoir les signaux délivrés par les capteurs (1-12, A-C).

2. Dispositif (15) selon la revendication 1,
dans lequel le ou les capteurs de compensation (A-C) est ou sont agencés symétriquement par rapport à un milieu (M) de la ligne (L).

3. Dispositif (15) selon la revendication 1 ou 2,
dans lequel un capteur de compensation (A-C) est agencé au début et à l'extrémité de la ligne (L).

4. Dispositif (15) selon l'une des revendications précédentes,
dans lequel la distance (D1) des capteurs de caractéristique de sécurité (1-12) par rapport au plan de transport (TE) est de 1,8 mm, de préférence de 1,3 mm et plus préférablement de 0,5 mm.

5. Dispositif (15) selon l'une des revendications précédentes,
dans lequel la distance (D2) du ou des capteurs de compensation (A-C) par rapport au plan de transport (TE) est de 5 mm à 10 mm et de préférence de 8 mm.

6. Dispositif (15) selon l'une des revendications précédentes,
dans lequel les capteurs (1-12, A-C) sont conçus sous la forme de capteurs magnétiques du même type.

7. Dispositif (15) selon l'une des revendications précédentes,
dans lequel le document de valeur (17) est l'un des suivants :

• un billet de banque ;
• un chèque ;
• une carte d'identité ;
• un passeport ;
• un titre de transport ;
• un certificat d'actions.

8. Procédé de compensation de valeur de mesure pour la détection d'une caractéristique de sécurité magnétique (17') d'un document de valeur (17) transporté à travers un dispositif selon les revendications 1-7 qui comporte au moins deux capteurs de caractéristique de sécurité (1-12) et au moins un capteur de compensation (A-C), dans lequel les capteurs (1-12, A-C) sont conçus sous la forme de capteurs magnétiques, le procédé comprenant, avant qu'un document de valeur (17) ne soit amené à passer devant les capteurs (1-12, A-C) :

• la détection (S100), par les capteurs de caractéristique de sécurité (1-12) et le capteur de compensation (A-C), d'une valeur de mesure respective ($M_i$, $M_j$),
• la détermination (S110) d'une grandeur de perturbation ($S_j$, $S_i$) du capteur de caractéristique de sécurité et de compensation (1-12, A-C) respectif sur la base de sa valeur de mesure ($M_i$, $M_j$),
• la détermination (S120) d'un facteur de pondération ($G_{ji}$) pour le capteur de caractéristique de sécurité (1-12) respectif en fonction d'une distance du capteur de caractéristique de sécurité (1-12) par rapport au capteur de compensation (A-C),
• le calcul (S130) d'un facteur de compensation ($K_{ji}$) pour le capteur de caractéristique de sécurité (1-12) respectif sur la base du rapport des grandeurs de perturbation ($S_j$, $S_i$) détectées du capteur de caractéristique de sécurité (1-12) et du capteur de compensation (A-C), ainsi que du facteur de pondération ($G_{ji}$),
• le calcul (S140) d'une valeur de compensation ($W_i$) pour le capteur de caractéristique de sécurité (1-12) respectif sur la base du facteur de compensation ($K_{ji}$) et de la valeur de mesure ($M_j$), et
• le calcul (S150) d'une valeur de mesure compensée ($kM_i$) du capteur de caractéristique de sécurité (1-12) respectif.

9. Procédé selon la revendication 8, comprenant en outre
la détection (S160) d'une caractéristique de sécurité (17') par utilisation de la valeur de mesure compensée ($kM_i$) lorsqu'un document de valeur (17) est amené à passer devant les capteurs (1-12, A-C).

**10.** Procédé selon la revendication 8 ou 9,
dans lequel la détermination (S110) de la perturbation ($S_j$, $S_i$) est effectuée par utilisation d'un écart-type ou d'une moyenne quadratique de plusieurs valeurs de mesure ($M_i$, $M_j$).

**11.** Procédé selon l'une des revendications 8 à 10, dans lequel, lorsqu'un seul capteur de compensation (A-C) est utilisé, un facteur de pondération ($G_{ji}$) qui est le même pour tous les capteurs de caractéristique de sécurité (1-12) est déterminé lors de la détermination (S120) du facteur de pondération ($G_{ji}$).

**12.** Procédé selon l'une des revendications 8 à 10, dans lequel, lorsque plusieurs capteurs de compensation (A-C) sont utilisés, un facteur de pondération par capteur de compensation (A-C) est déterminé lors de la détermination (S120) du facteur de pondération ($G_{ji}$) pour un capteur de caractéristique de sécurité (1-12) respectif, lequel facteur de pondération diminue lorsque la distance entre le capteur de caractéristique de sécurité (1-12) et le capteur de compensation (A-C) associé augmente.

**13.** Procédé selon l'une des revendications 8 à 12, dans lequel, lorsqu'un seul capteur de compensation (A-C) est utilisé, une extrapolation du rapport des grandeurs de perturbation du capteur de compensation (A-C) est effectuée sur la base du facteur de pondération ($G_{ji}$) lors du calcul du facteur de compensation (S130) pour le capteur de caractéristique de sécurité (1-12), ou, lorsque plusieurs capteurs de compensation (A-C) sont utilisés, une interpolation linéaire par morceaux du rapport des grandeurs de perturbation est effectuée entre les capteurs de compensation (A-C) sur la base des facteurs de pondération ($G_{ji}$).

**14.** Procédé selon l'une des revendications 8 à 13, dans lequel une valeur de l'ordre de grandeur du bruit de signal des capteurs (1-12) est ajoutée au facteur de pondération lors de la détermination (S120) du facteur de pondération ($G_{ji}$).

Figur 1

Figur 1A

Figur 1B

Figur 2

Figur 3

starke Störung    schwache Störung    keine Störung

Figur 4

starke Störung   schwache Störung   keine Störung

Figur 5

```
                    ┌─────────────┐
                    │    Start    │
                    └──────┬──────┘
                           │
        ┌──────────────────▼──────────────────┐
        │  Erfassen der Messwerte ohne Banknote │ ──── S100
        └──────────────────┬──────────────────┘
                           │
        ┌──────────────────▼──────────────────┐
        │       Ermitteln der Störgröße       │ ──── S110
        └──────────────────┬──────────────────┘
                           │
        ┌──────────────────▼──────────────────┐
        │   Ermitteln des Gewichtungsfaktors  │ ──── S120
        └──────────────────┬──────────────────┘
                           │
        ┌──────────────────▼──────────────────┐
        │  Berechnen des Kompensationsfaktors │ ──── S130
        └──────────────────┬──────────────────┘
                           │
                  ◇ Banknote an den ◇ ── nein
                    Sensoren?
                           │ ja
        ┌──────────────────▼──────────────────┐
        │   Berechnen des Kompensationswerts  │ ──── S140
        └──────────────────┬──────────────────┘
                           │
        ┌──────────────────▼──────────────────┐
        │ Berechnen des kompensierten Messwerts │ ──── S150
        └──────────────────┬──────────────────┘
                           │
        ┌──────────────────▼──────────────────┐
        │  Verwenden des kompensierten Messwerts│
        │        beim Nachweis eines           │ ──── S160
        │   Sicherheitsmerkmals der Banknote   │
        └──────────────────┬──────────────────┘
                           │
                    ┌──────▼──────┐
                    │     Ende    │
                    └─────────────┘
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20170352222 A1